# EUROPEAN PATENT APPLICATION

(11) **EP 1 906 237 A2**
(43) Date of publication of application: **02.04.2008**
(21) Application number: 07253158.5
(22) Date of filing: 10.08.2007
(51) Int. Cl.: G03F 7/00, G02B 5/30

(54) **Nanostructured pattern method of manufacture**

(30) Priority: 11.08.2006 US 502764
(71) Applicant: Rohm and Haas Denmark Finance A/S, 2100 Copenhagen (DK)
(72) Inventor: Jagannathan, Ramesh, Rochester, New York 14650 (US); Rao, YuanQiao, Rochester, New York 14650 (US); MI, Xiang-Dong, Rochester, New York 14623 (US)
(74) Representative: Buckley, Guy Julian

(57) **Abstract**

The invention relates to a method of forming a nanostructured pattern on a substrate. The steps include providing a substrate and coating the substrate with functional material to form a layer of functional material. A block copolymer of at least an A polymer chain and a B polymer chain is coated on the functional material to forma a layer. The block copolymer is dried to form ordered nanodomains. The A polymer chain of the dried block copolymer is removed to form voids and the functional material is then removed from where the A polymer chain has been removed.

## Description

### FIELD OF THE INVENTION

The present invention is related to the nanostructured pattern formed from block copolymers, and is related to using these nanostructured features of the block copolymers as template to form nanoscale, ordered functional features on flexible substrates and is also related to using the nanostructured features of one of the polymer phases in the copolymer to be the ordered functional feature(s) itself and is also related to filling the copolymers with nanomaterials and using the nanostructured features of one of the filled polymer phases in the copolymer to be the ordered functional feature(s) itself. The present invention is also related specifically to the low cost manufacture of a conductive wire grid polarizer on flexible substrates. The present invention is also related specifically to the creation of an array of metal wires, of any shape, with a long-range order in at least in one direction, with a periodicity in the nanometer length scale in that dimension. The diameter or height of the wires is in the nanometer size and the lengths could be several micrometers.

### BACKGROUND OF THE INVENTION

The processes that are currently available to produce nanoscale patterns on substrates are vacuum based technologies and are generally expensive. Moreover, the photolithographic technologies used in these processes have generally a lower limit in terms of resolution of the nanoscale patterns, which is imposed by the wavelength of light. New technological approaches are taken to reduce both the cost and feature size. A very promising new technology is the directed self-assembly of di-block co-polymers to create fine nanoscale patterns on substrates at ambient conditions.

A key aspect of this technology is the term "directed self-assembly". The process generally involves coating the di-block polymers on a substrate under the influence of a directional force. The directional force can be as simple as a confinement space whose dimensions are comparable to the dimensions of the desired nanoscale patterns, or an electric or magnetic field. It could be an electrostatic field manifest as hydrophobic or hydrophilic features on the substrate.

By directing the self-assembly of the elements and by biasing the arrangement of the arrays on a surface, unprecedented aerial densities of nanoscale features can be achieved. When block copolymers of polystyrene-b-poly (ethylene oxide) were coated onto a silicon substrate where trenches (about 2 micron in width) were photo lithographically placed on a surface, within each trench are arrays of hexagonally packed, nanoscopic cylindrical domains where each cylinder is ~20 nm in size and each array is in orientational registry with the arrays in adjoining trenches. Most importantly is the fact that the block copolymer, by controlling the preparation conditions, self-assembled into the structure shown with no external manipulation of the morphology.

Nealey and coworkers at the University of Wisconsin (Kim, S.O.; Solak, H.H.; Stoykovich, M.P.; Ferrier, N.J.; de Pablo, J.J.; Nealey, P.F.; Nature, 2003, 424, 411) took an alternate approach in controlling the lateral placement of these nanoscopic domains. They coated block copolymer of polystyrene-b-poly (methyl methacrylate) onto a surface that was patterned using soft x-rays. The surface patterning was done on a size scale commensurate with the size of the copolymer domains and each domain was directed on the surface. Without patterning, the lamellar domains (in this case) were randomly oriented on the surface. With patterning a precise distribution of the domains across the surface was achieved.

We will discuss in detail, a very specific product, known as the wire grid polarizer. Wire grid polarizers have been used in projection displays as pre-polarizers, analyzers, and polarizing beam splitters [1-3]. They have many advantages, including high heat and high light flux tolerance. They have also been used as reflective polarizers for polarization recycling [4-6]. A low fill-factor wire grid polarizer is disclosed in copending patent application to Mi et al., US Patent Application No. 2006/0061862. The following additional references are background for the present invention.
[1] E. Hansen, E. Gardner, R. Perkins. M. Lines, and A. Robbins, "The Display Applications and Physics of the ProFlux Wire Grid Polarizer", SID 2002 Symposium Digest Vol. 33, pp. 730-733, (2002).
[2] A.F. Kurtz. B.D. Silverstein, and J.M. Cobb, "Digital Cinema Projection with R-LCOS Displays", SID 2004 Symposium Digest Vol. 35, pp. 166-169, (2004).
[3] J. Chen, M. Robinson, and G. Sharp. "General Methodology for LCoS panel Compensation", SID 2004 Symposium Digest Vol. 35, pp. 990-993, (2004).
[4] T. Sergan, J. Kelly, M. Lavrentovich, E. Gardner, D. Hansen. R. Perkins, J. Hansen, and R. Critchfield, "Twisted Nematic Reflective Display with Internal Wire Grid Polarizer", SID 2002 Symposium Digest Vol. 33, pp. 514-517, (2002).
[5] J. Grinberg, and M. Little, "Liquid Crystal Device", U.S. Patent No. 4,688,897 (1987).
[6] D. Hansen, and J. Gunther, "Dual Mode Reflective/Transmissive Liquid Crystal Display Apparatus", U.S. Patent No. 5,986,730 (1999).

### [You will need to provide copies of the referenced articles]

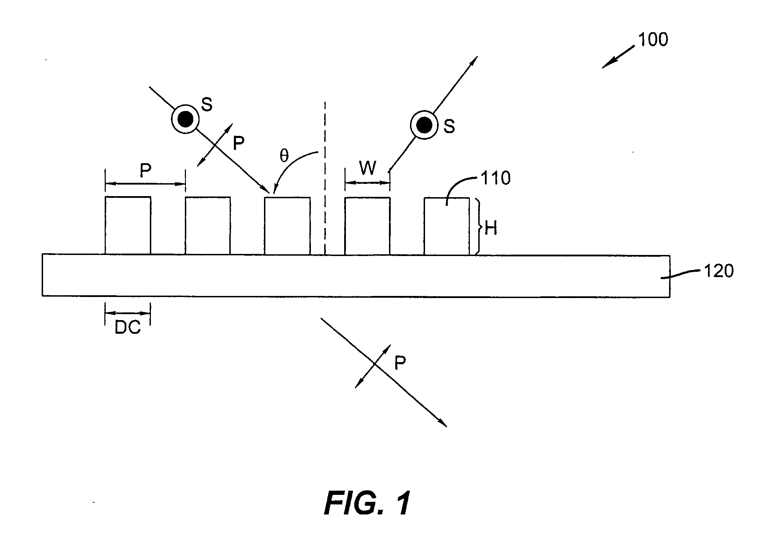

A wire grid polarizer is schematically shown in Figure 1, where P, W, and H specify the pitch, width, and height of the wires, respectively. Ideally, the pitch P of the wires should be as small as possible and should be less than 1/3 of the wavelength of interest. It is only limited by manufacturing processes. For a wire grid polarizer designed for the use of visible light, the pitch is ~140 nm, and the height is also ~140 nm. The wires are made of aluminum, which has superior optical properties. When unpolarized light is incident upon the wire grid polarizer, light of S-polarization (parallel to the wires) is reflected back, and light of P-polarization (perpendicular to the wires) is transmitted. The wire grid polarizers have been fabricated using by commonly known processes. For example, both Garvin, in U.S. Patent 4,049,944, and Ferrante, in U.S. Patent 4,514,479, describe the use of holographic interference lithography to form a fine grating structure in photoresist, followed by ion beam etching to transfer the structure into an underlying metal film. Stenkamp ("Grid Polarizer For The Visible Spectral Region", Proceedings of the SPIE, vol. 2213, pages 288-296) describes the use of direct e-beam lithography to create the resist pattern, followed by reactive ion etching to transfer the pattern into a metal film. Other high-resolution lithography techniques, including extreme ultraviolet lithography and X-ray lithography could also be used to create the resist pattern. Other techniques, including other etching mechanisms and lift-off processes, could be used to transfer the pattern from the resist to a metal film.

The above processes have the following problems:
1) In general, the pitch of the wire grid polarizer is preferred to be as small as possible for better optical performance in terms of transmission and reflection, acceptance angle, and spectral dependence. However, the pitch that can be achieved is fundamentally limited by the wavelength of the light source and the index of refraction of the photoresist used in corresponding lithography techniques. A wire grid polarizer of short pitch requires a light source with short wavelength and a photoresist with low index of refraction, but they are not readily available for meeting the ever-growing requirement of shorter pitch.
2) The above processes require a rigid glass substrate to hold the metal wires and photoresist. Though rigid and flat, plastic substrates might be used to replace the glass substrate, the high temperature and chemicals used in the subsequent process make most plastic substrates difficult to use.

What is needed, therefore, is a method of forming a wire grid polarizer in mass production.

### PROBLEM TO BE SOLVED BY THE INVENTION

Generally, it would be desirable to form a nanostructured pattern of a functional material. Furthermore, it would be desirable to form a nanostructured pattern of a functional material, which has been filled with nanoparticles, which are magnetic, conductive, semi-conductive or insulating with desirable optical properties such as refractive index, photoluminescence, etc.

It would also be desirable to form nanostructured patterns of a functional material containing desirable biological properties. Furthermore, it would be desirable to have these nanostructures with specific reactive species, which upon exposure to certain environment would, by a physical, chemical or biological reaction, create a nanopatterned structure of a new set of species, which are produced through this reaction.

Specifically, it would be desirable to form a nanostructured conductive pattern. It would be desirable to form a nanostructured pattern using continuous process. Furthermore, it would be desired to form a nanostructured aluminum pattern on a substrate, which can be used as a wire grid polarizer. Furthermore, it would be desired to form a wire grid polarizer with low fill factor.

It is an object of the invention to form a nanostructured pattern of functional material on a substrate.

It is an object of the invention to form a nanostructured pattern of a functional material, which is inorganic, organic or polymeric on a substrate.

It is an object of the invention to form a nanostructured pattern of a functional material, which is inorganic, organic or polymeric and containing nanoparticles which can be magnetic, conductive, semi-conductive, or insulating, on a substrate.

It is an object of the invention to form a nanostructured pattern of a biological functional material such as DNA, on a substrate.

It is an object of the invention to form a nanostructured pattern of a functional material, which is inorganic, organic, polymeric or biologic which can be activated to react and produce a new nanopattemed species, on a substrate.

It is an object of the invention to form a nanostructured conductive pattern on a substrate.

It is another object to provide a method of forming nanostructured patterns of mass production.

It is a further object to form nanostructured patterns such as a wire grid polarizer using a mass production process.

It is a further object to form a wire grid polarizer of low fill factor.

These and other objects of the invention are accomplished by a method of forming a pattern on a substrate comprising providing a substrate, coating said substrate with a functional material, coating said functional layer with a block copolymer of at least an A and B polymer chains with or without nanoparticles, drying said block copolymer to form ordered nano-domains, removing the A polymer phase of the dried block copolymer and the area of the functional material below the phase removed.

### SUMMARY OF THE INVENTION

The invention relates to a method of forming a nanostructured pattern on a substrate. The steps include providing a substrate and coating the substrate with functional material to form a layer of functional material. A block copolymer of at least an A polymer chain and a B polymer chain is coated on the functional material to forma a layer. The block copolymer is dried to form ordered nanodomains. The A polymer chain of the dried block copolymer is removed to form voids and the functional material is then removed from where the A polymer chain has been removed.

### ADVANTAGEOUS EFFECT OF THE INVENTION

The invention provides a low cost production method of nanostructured functional materials such as wire grid polarizer. The invention also provides a general method to produce nanostructured conductive, semi-conductive, magnetic, insulating or biologic patterns. The technique described here for creating nano scale arrays is significantly advantaged with respect to conventional vacuum based processes currently used to create them. The techniques are amenable to manufacture, in that they are simple, fast, and cost-effective. They are readily adoptable by industry and compatible with other fabrication processes. The techniques described herein significantly advance the general utility of nanofabrication by self-assembling copolymer templates.

The invention also provides a low cost production method for creating high aerial density of nanoscale features of different shapes and forms on a flexible substrate, under ambient conditions. There is no other competing technology currently available which is capable of providing such features at low cost. This technology uses currently available manufacturing capabilities in an innovative manner to rapidly bring to market a truly low cost nanofabrication technology, which does not exist right now. The potential product applications are electronic display devices such as television, mobile phones and electronic products such as digital music systems, computers etc.

This is especially important in the current global market place where a new "lower middle class" consumer base which is five times larger in size compared to the current middle class numbers, is being created.

Other features and advantages of the invention will be apparent from the following detailed description, and from the claims.

### BRIEF DESCRIPTION OF THE DRAWINGS

Figure 1 is a schematic view of a wire grid polarizer.
Figure 2 a) and 2 b) show two morphologies or di-block polymers after their phase separation.
Figure 3 is a manufacturing process flow diagram of mass production of a nanostructured conductive pattern.
Figure 4 is a series of schematics of various di-block copolymer morphologies that are spontaneously formed during their phase separation process.
Figure 5 shows a microreplicated structure
Figure 6 (a) -6 (f) show a series of the exemplary process of making a wire grid polarizer.

For a better understanding of the present invention along with other objects, advantages and capabilities thereof, reference is made to the following description and appended claims in connection with the above-described drawings.

### DETAILED DESCRIPTION OF THE INVENTION

The invention has numerous advantages. We will illustrate the invention by specifically describing the details of the method to manufacture wire grid polarizer in a mass production process as an example. The invention provides a new method to manufacture different nanostructured patterns, for example, wire grid polarizer, on a patterned substrate.

A manufacturing method for low cost fabrication of nano-scale metallic wire grid arrays on a flexible substrate such as PET is described, although such manufacturing method can be used on glass. These wire grid arrays of metals (e.g. aluminum) are useful as optical polarizers. This is accomplished by patterning block copolymer templates with selective exposure to a radiation source. These di-block patterns are created on metallized plastic substrates, which may or may not be pre-coated with a random mixture of each polymer of the block copolymer compound. The metallized plastic substrate with or without the random polymer mixture coating is previously patterned with alternating patches which are micro-replicated grooves/ledges or treated with the LCD type alignment process (e.g. rubbing) to induce certain ordering tendencies on the surface for the di-block copolymers during their phase segregation. All these pre-treatment procedures guide and direct the phase separating features on the plastic substrate to align in an ordered fashion. The compositions of di-block polymers are chosen to provide the desired surface features such as nanosized lamellar (wire) arrays.

The template is then subjected to post-fabrication steps such as cross-linking, to chemically and physically further distinguish the two polymeric components in the di-block. One of the polymer compounds and the underlying metal layer are then removed in a spatially selective fashion by dissolution, etching, etc. The second polymer feature is subsequently removed by another dissolution or etching process to reveal the nano lamellar (wire) grid assembly on the plastic substrate.

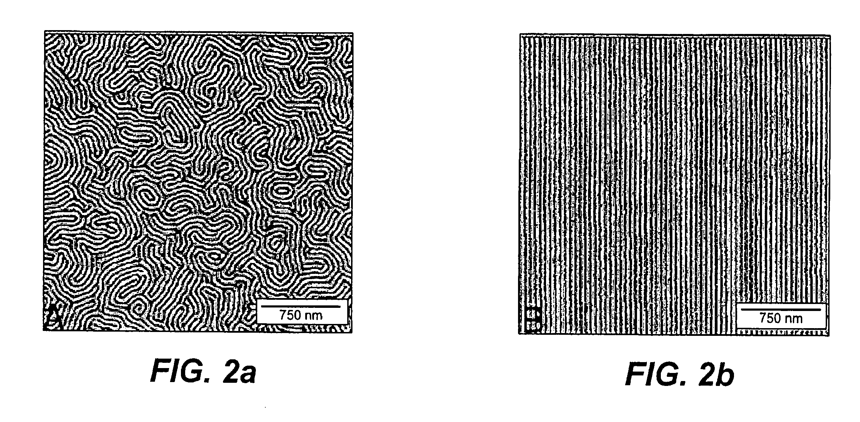

In one aspect of the invention, we use a plastic (e.g. PET) substrate with a topographic pattern of shallow, micro-grooves/ledges created by a micro-replication process to guide and direct the di-block copolymer self-assembly. The plastic substrate itself is of macroscopic dimensions and the grooves and ledges are microscopic in nature. The ledges and troughs are then uniformly coated with a thin layer of metal such as aluminum. A thin coating of a di-block copolymer of interest is then put on the metallized substrate. In the case of the cylindrical forming di-block copolymer, cylindrical rods are formed from one of the polymers. It has been shown that the self assembling of the di-block copolymer and the orientation of one of the phases can be controlled topologically. Nealey and coworkers at the University of Wisconsin coated a block copolymer of polystyrene-b-poly (methyl methacrylate) onto a surface that was patterned using soft x-rays. The surface patterning was done on a size scale commensurate with the size of the copolymer domains and each domain was directed on the surface. Without patterning, the lamellar domains (in this case) were randomly oriented on the surface (Fig 2(a)). With patterning a precise distribution of the domains across the surface was achieved (Fig 2 (b)). The substrate topography influences and aligns the orientation of the phase separating polymer blocks in the direction of the grooves and ledges. External forces, such as electrostatic, magnetic, fluid shear etc. may be applied during the phase separation process to expedite the process at lower temperatures.

As used herein, the term "nano" refers to a characteristic size range, for example, of arrays, that are attained using the methods of self-assembly of copolymer molecules described herein. For example, the wire diameter, the wire lengths and the period of the array can be in the nanosize range, that is, within a range of about a nanometer to over a thousand nanometers. "Nano wires" can also refer to material that is not necessarily limited to electrically conductive, but is nevertheless useful when present in nanoscale arrays. As used herein, the term "wire" refers to conductive material having width and length, where the aspect ratio (that is the ratio of length to width) is at least 2:1. In this application, the term "multilevel" refers to structures that can be constructed by multiple, independent levels of lithography, with at least one level created with a laterally patterned diblock copolymer film. As used herein, the term "multilayering" will refer to a structural element within a single layer of lithography that contains more than one material.

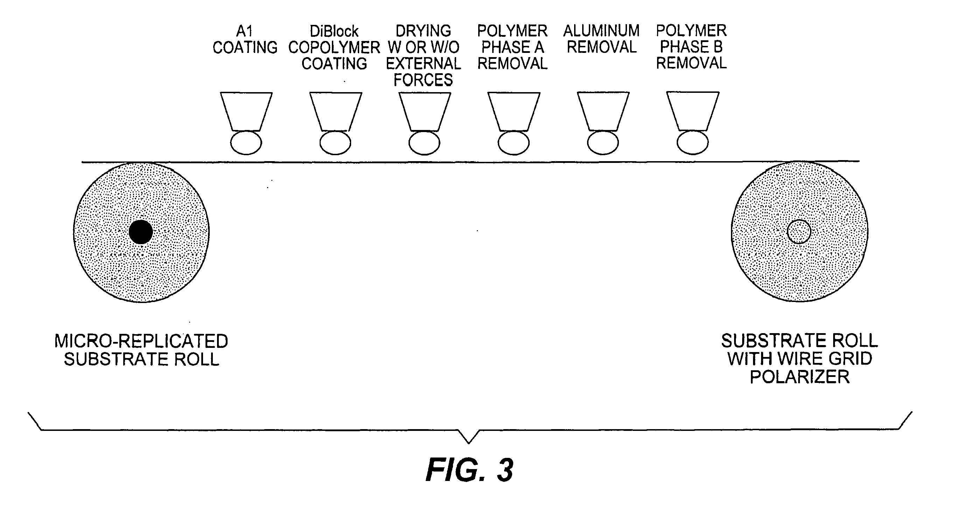

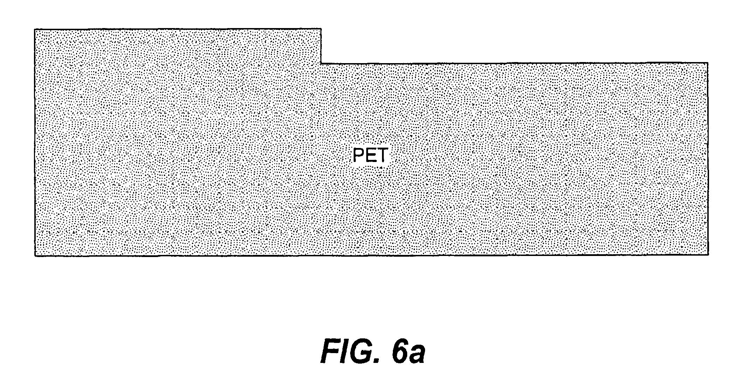

The inventive manufacturing flow of the nanostructured conductive pattern is shown in Figure 3 and illustrated in more detail in Figure 6 (a)-6 (f).

The substrate is made from polymer resins through extrusion. The substrate can be made of any optical polymeric material, although glass can also be used as a substrate. It can be radical polymer or condensation polymer. It can be hydrophobic or hydrophilic polymer. It can be any natural or synthetic polymer. The substrate polymer of the invention can be of different architecture: linear, grafted, branch or hyper branched. The polymer may be a thermoplastic. Illustrative of useful thermoplastic resins are cellulose and its derivatives (cellulosic): cellulose ethers such as methyl cellulose, ethyl cellulose, hydroxyethyl cellulose, hydroxypropyl cellulose, and cyanoethyl cellulose, and cellulose esters such as triacetyl cellulose (TAC), diacetyl cellulose (DAC), cellulose acetate propionate (CAP), cellulose acetate butyrate (CAB), cellulose acetate phthalate, cellulose acetate trimellitate and cellulose nitrate. The polymer can include polyolefins such as (linear) low and high density poly(ethylene), poly(propylene), chlorinated low density poly(ethylene), poly(4-methyl-1-pentene), and poly(ethylene) and cyclic polyolefins; poly(styrene); polyxylyene; polyimide; vinyl polymers and their copolymers such as poly(vinylcarbazole), poly(vinyl acetate), poly(vinyl alcohol), poly(vinyl chloride), poly(vinyl butyral), poly(vinylidene chloride), ethylene-vinyl acetate copolymers, and the like; polyacrylics their copolymers such as poly(ethyl acrylate), poly(n-butyl acrylate), poly(methylmethacrylate), poly(ethyl methacrylate), poly(n-butyl methacrylate), poly(n-propyl methacrylate), poly(acrylamide), polyacrylonitrile, poly(acrylic acid), ethylene-acrylic acid copolymers; ethylene-vinyl alcohol copolymers; acrylonitrile copolymers; methyl methacrylate-styrene copolymers; ethylene-ethyl acrylate copolymers; methacrylated butadiene-styrene copolymers, and the like; polycarbonates such as poly(methane bis(4-phenyl) carbonate), poly(1,1-ether bis(4-phenyl) carbonate), poly(diphenylmethane bis(4-phenyl)carbonate), poly(1,1-cyclohexane bis(4-phenyl)carbonate), poly(2,2-bis-(4-hydroxyphenyl) propane)carbonate and the like; polyether; polyketone; polyphenylene; polysulfide; polysulfone; polylactones such as poly(pivalolactone), poly(caprolactone) and the like; polyurethanes; linear long-chain diols such as poly(tetramethylene adipate), poly(ethylene adipate), poly(1,4-butylene adipate), poly(ethylene succinate), poly(2,3-butylenesuccinate), polyether diols and the like; polyether ether ketones; polyamides such as poly (4-amino butyric acid), poly(hexamethylene adipamide), poly(6-aminohexanoic acid), poly(m-xylylene adipamide), poly(p-xylyene sebacamide), poly(2,2,2-trimethyl hexamethylene terephthalamide), poly(metaphenylene isophthalamide) (Nomex^{™}), poly(p-phenylene terephthalamide)(Kevlar^{™}), and the like; polyesters such as poly(ethylene azelate), poly(ethylene-1,5-naphthalate), poly(ethylene-2,6-naphthalate), poly(1,4-cyclohexane dimethylene terephthalate), poly(ethylene oxybenzoate) (A-Tell^{™}), poly(para-hydroxy benzoate) (Ekonol^{™}), poly(1,4-cyclohexylidene dimethylene terephthalate) (Kodel^{™}) (cis), poly(1,4-cyclohexylidene dimethylene terephthalate) (Kodel^{™}) (trans), polyethylene terephthlate, polybutylene terephthalate and the like; poly(arylene oxides) such as poly(2,6-dimethyl-1,4-phenylene oxide), poly(2,6-diphenyl-1,4-phenylene oxide) and the like; poly(arylene sulfides) such as poly(phenylene sulfide) and the like; polyetherimides; ionomers; poly(epichlorohydrins); furan resins such as poly(furan); silicones such as poly(dimethyl siloxane), poly(dimethyl siloxane), poly(dimethyl siloxane co-phenylmethyl siloxane) and the like; polytetrafluoroethylene; and polyacetals. Copolymers and/or mixtures of these aforementioned polymers can also be used.

Preferred substrate polymers include thermoplastic polymers such as polyester, vinyl, polystyrene, polyacrylic, and polyxylyene, polyvinylcarbazole, polyamide, polyimide, polycarbonate, polyether, polyketone, polyphenylene, polysulfide, polysulfone, and cyclic polyolefin. More preferred substrate polymer are PET and Bisphenol A polycarbonate.

Substrates can be of different thickness ranging from 10 micron to 1 centimeter.

The substrate is subjected to micropatterning process. A micropattern is generated on the substrate. Different micropatterning process can be utilized. The pre-patterning can be mechanical or other well established alignment techniques. For example, the pre-patterning can be due to the presence of micro-replicated ledges/grooves of an arbitrary, desired shape and form. Micro-replication (US Patent 6,800,234(B2X6)) is a generally recognized, low cost way to topographically pattern a flexible substrate. Another example of controlling surface energetics of the substrate is to use the alignment technique commonly used in the LCD industry, usually referred to as "rubbing". In this specific invention we would use "pre-rubbing" of the plastic substrate to align and direct the self-assembly of di-block copolymers structures. The method of using the pre-patterned substrate does not preclude the use of other external forces, such as electric fields, magnetic fields, shear forces etc. to aid and expedite the alignment process. It can be also patterned using coatings of patches of hydrophobic and hydrophilic polymers. Preferably, it can be patterned with alternating patches, which are micro-replicated grooves/ledges. The micropattern is preferred to be a shallow regular array of grooves with flat bottom. The pitch of the grooves is preferred to be higher than 1 micron and less than 10 micron. The height of the grooves is preferred to be higher than 100nm and less than 1 micron.

In the present invention the process of preparation of the wire grid polarizer involves conformally depositing a thin layer of conductive material on the micropatterned substrate. The conductive material can be different metals, transparent metal oxides or conducting polymers. Metals can be Aluminum, Silver, Gold, Nickel and Copper. Metal oxides can be indium tin oxide (ITO), and antimony tin oxide (AZO), etc. Conducting polymers can be polythiophene, polyaniline, and polyacetylene and etc. The method deposition is corresponding to the material being deposited. It can be either vacuum process or ambient air process. It can be plasma, or sputtering. It can also be solution coating. The thickness of the conductive material is larger than 50 nm and less than 1 micron. It is further preferred to be larger than 100 nm and less than 200 nm.

As a next step in the preparation of the wire grid polarizer by our process, a block copolymer that may or may not contain nanoparticles is coated onto the aluminum coating and the ordered phase separation is formed during the drying of the coating or after the annealing of dried film.

The drying of the polymer phases can be achieved by several conventionally available methods. For example, hot rollers, which simultaneously apply directional pressure and shear and also heat. Heat can also be applied by other means such as an IR source, microwave source, resistive wire coils, hot air or gas or a combination of both. Heat can be applied through radiation sources as well. Another example can be simultaneous application of an electric field when heat is applied to dry the polymer coatings. The heat can be applied through heat rollers, which are electrified. If the rollers are not electrified, then the electric field may be applied by means commonly used such a corona device. We can conceive of applying heat, electric field and shear forces simultaneously as well by combinations of techniques such as the ones listed above. The concept is general in scope and is not limited to the nature of the application technique.

Block Copolymers (Di-block, tri-block, tetra-block, star-block, graft-block) can be used for creation of periodic structures at the nanoscale (less than 100 nm). [Stoykovich et al., "Directed Assembly of Block Copolymer Blends into Nonregular Device-Oriented Structures", Science 308, pp.1442-1445 (2005)]

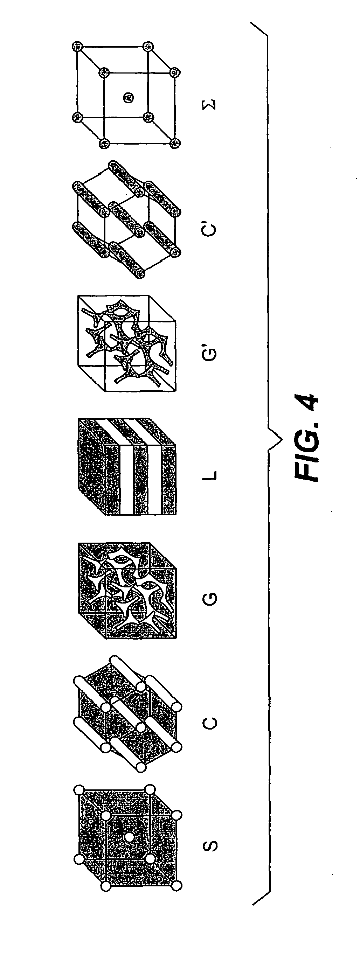

Block Copolymers (Di-block, tri-block, tetra-block, star-block, graft-block) can be used for creation of periodic structures at the nanoscale (less than 100 nm). [Stoykovich et al., "directed Assembly of Block Copolymer Blends into Nonregular Device-Oriented Structures", Science 308, pp.1442-1445 (2005)]. Block copolymer is formed by linking two or more incompatible polymer chains together at the end. The phase separation is determined by the size of the polymer chain, typically tens of nanometers in size, and the interaction between the chains. By changing the length of the chains linked together, the volume fraction of the components can be controlled and ordered morphologies, ranging from body-centered arrays of spherical domains (S) to hexagonally-packed cylindrical domains (C) to gyroids (G) to alternating lamellar domains (as shown in Figure 4) spontaneously form when mobility is imparted to the chains. The phase inversion changes as the volume ratio of the polymers change. Then the inversed hexagonally-packed cylindrical domains (C*), gyroids (G*), and the inversed spherical domains (S*) formed.

In thin films, by controlling the orientation of these domains and by selectively removing one of the components by standard photolithographic processes or by use of phase selective chemistries, a wealth of opportunities emerge for the use of these arrays of nanoscopic elements as templates and scaffolds for the fabrication of novel devices and structures. The control over the orientation of these elements rests in controlling the thickness of the film relative to the period of the block copolymer morphology (commensurability) and manipulating the manner in which the two blocks interact with the underlying substrate and surface. For example, when a spin-coated film of a polystyrene-b-poly (methyl methacrylate) diblock copolymer was placed on a passivated silicon substrate and heated above its glass transition temperature, the scanning force micrograph shows cylinders of PMMA oriented normal to the films surface and the cylinders penetrate through the entire film. Upon exposure to UV radiation and an alcohol rinse (a standard industrial practice) a nanoporous film is produced where the pore-size is identical to the size of the cylindrical domains of the original copolymer. Such nanoporous films are being used as templates for the fabrication of floating gates in flash memory applications and as scaffolds for the generation of nanoscopic magnetic elements for storage devices.

The block copolymer suited for this invention can be of different chemical nature. It can be made from anionic, cationic or living radical polymerization. A block polymer of interest can comprise more than one block. It can be diblock, triblock, tetra-block, star-block, and graft-block. One of the blocks can comprise random copolymer. One of the blocks can crystallize. One of the blocks can be liquid crystal. One of the blocks can be plastic at room temperature. One of the blocks can be rubbery at room temperature. One of the blocks can be hydrophobic. One of the blocks can be hydrophilic. Examples of polymers can be used to form the block copolymer include but not limit to poly(styrene); polyxylyene; vinyl polymers such as poly(vinylcarbazole), poly(vinyl acetate), poly(vinyl alcohol), poly(vinyl chloride), poly(vinyl butyral), poly(vinylidene chloride), ethylene-vinyl acetate copolymers, and the like; polyacrylics such as poly(ethyl acrylate), poly(n-butyl acrylate), poly(methylmethacrylate), poly(ethyl methacrylate), poly(n-butyl methacrylate), poly(n-propyl methacrylate), poly(acrylamide), polyacrylonitrile, poly(acrylic acid), ethylene-acrylic acid copolymers; ethylene-vinyl alcohol copolymers; acrylonitrile copolymers; methyl methacrylate-styrene copolymers; ethylene-ethyl acrylate copolymers; methacrylated butadiene-styrene copolymers, and the like; polydiene such as poly(butadiene), poly(isobutylene), poly isoprene, polyether such as polyethylene oxide, polypropylene oxide and the like; polyol such as polyvinyl alcohol and the like, polyvinyl acetate and acetal. Examples of diblock copolymer include polystyrene-acrylate. The acrylate can be methylmethacrylate.

Some useful diblock copolymers are polystyrene-polymethylmethacrylate, polystyrene-polybutadiene, polystyrene-polyethylene oxide. The number molecular weight is in the range of 1000 to 100,000 g/mol and the volume fraction of one block is in the range of 0.3 to 0.7.

In one embodiment, a diblock copolymer phase-separates into a lamellar structure with the phase perpendicular to the plane of the substrate. The length of phase A and B is 10 nm to 100 nm. The preferred length of phase A of the di-block copolymer is 10 to 20 nm and the preferred length of phase B is 20 to 50 nm. A useful di-block copolymer, for example, is made up of polystyrene-block-polybutadiene. Another useful diblock copolymer is polystyrene-b-poly(methyl methacrylate). With a number molecular weight of 14,600 and a volume fraction of 0.5 of polystyrene, the block copolymer formed lamellar structure with the periodic phase length of 15 nm. (Corvazier et al, J. Mater Chem, 2001, 11,2864) It is also known that semi crystalline diblock copolymer tends to form lamellar structure.

The polymer A phase is then removed by etching and or a dissolution process. In the case of polystyrene-b-poly (methyl methacrylate), polymer A phase is poly(methyl methacrylate) (PMMA) and polymer B phase is polystyrene (PS). By exposing the film to UV radiation, polymer A phase, PMMA, is decomposed and polymer B phase, PS, is cross-linked. PMMA is a standard photoresist used routinely in the microelectronics industry. In the case of polystyrene-b-poly (butadiene), exposing the fills to ozone will crosslink the PS (phase B polymer) and degrade the poly (butadiene) (Phase A polymer). In numerous other block copolymer systems, the minor component comprising the nanoscopic cylindrical domains can be selectively removed.

The present invention then requires the removal of the aluminum, or other conductive material underneath the phase A polymer by an etch process using the segments of remaining polymer (resist) as a mask. The criterion for a good etch process is to have a large window for the parameters such as etch time and the degradation of the resist. The etch process can be divided into two methods; dry and wet.

In wet aluminum etches, the components are phosphoric, acetic, and nitric acid (PAN etch). These components can be varied to achieve different etch rates and selectivity with other metals which may be present. Wet etches suffer from the fact that they are very isotropic. What this yields is a sloped profile due to undercutting of the polymeric resist mask. It is difficult to get very high aspect ratios using wet etches on non-crystalline materials.

The most common dry etch process for aluminum is reactive ion etching (RIE). Reactive ion etching uses microwaves to generate a plasma in a low-pressure gas. The gas has a component which, when excited, can generate reactive species such as radicals and ions. The ions can be accelerated to electrodes. Typically the sample is in close proximity to the one of the electrodes. The ions are thus directed at a specific angle, usually vertical, onto the sample. The ions react with the surface and chemically etch the material.

Aluminum is usually reactive ion etched with a halogen-based plasma. Carbon tetrachloride or chloroform serve as a halogen precursor and is mixed with an inert gas. The plasma generates chlorine radical ions, which react with aluminum to form volatile aluminum trichloride. This type of aluminum etching can give high aspect ratio walls due to the anisotropy if the ion flow direction. Since chloride radical ions react slowly with most organics to create volatile species, the resist gives good discrimination during the etching.

Finally, a conductive pattern is formed on a micropatterned substrate by removing Polymer B.

The invention is also general in the sense, we could visualize use of several shapes and sizes of grooves on the plastic substrate, to guide and direct self-assembly of di-block copolymer phase separation features, such as circles, triangles, cylinders, pyramids, etc. which can be subsequently used as templates/masks to deposit spatially arranged materials of practical interest such as metals, semi-conductors magnetic materials etc. The invention can be generalized to use one of the polymers in the block copolymer as a functional feature itself. By pre-filling the copolymers with nanomaterials with specific properties, one can creating nano-features with novel properties, for example, metallic, semi-conducting or insulating and removing one of the polymers. These ordered nano-features may or may not be positioned on conductive surfaces.

These and other advantages will be apparent from the detailed description below.

The following example illustrates the practice of this invention. It is not intended to be exhaustive of all possible variations of the invention. Parts and percentages are by weight unless otherwise indicated.

### EXAMPLE

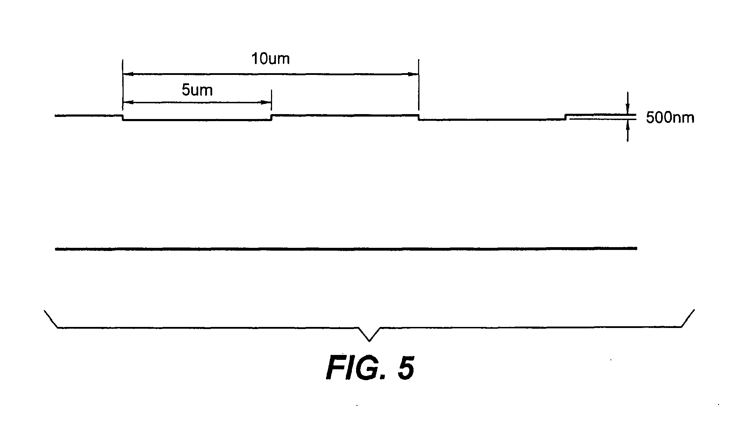

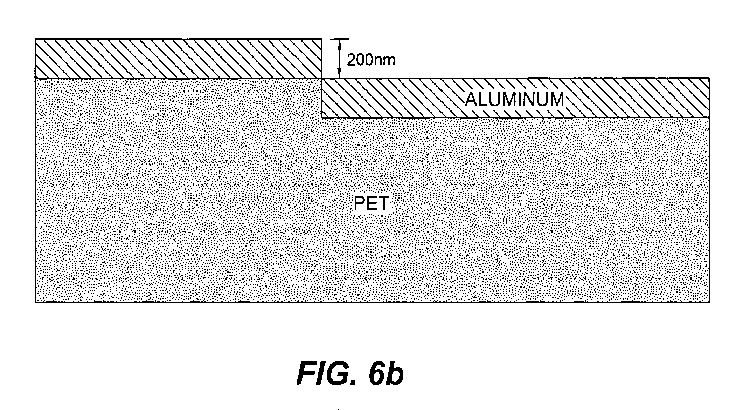

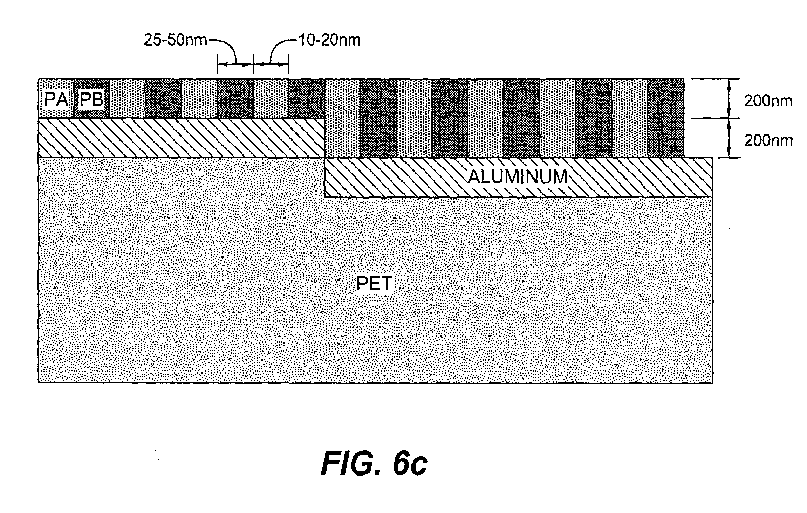

A sheet or roll of flexible plastic such as PET is pre-patterned by the micro-replication process to yield an array of rectangular grooves as shown in Figure 5 and Figure 6(a). P, W and D specify the pitch, wall width and height of the grooves and the grooves run across the entire length of the flexible substrate which arbitrary and/or determined by manufacturing capabilities. The pitch (P) of the grooves can vary anywhere from 1 micron to 100 micron but preferably in the 5 micron to 25 micron range. The wall width (W) of the groove can range from 0.5 micron to 25 micron, preferably in the 1 micron to 10-micron range. The depth of the groove (D) can range from 0.25 micron to 5 micron, preferably in the 0.5 micron to 1-micron range. The flexible sheet or roll is then coated in a conformal fashion with a thin layer of metal, preferably aluminum (Figure 6 (b)). The thickness of the metal layer can range from 0.05micron to 0.5 micron, preferably in the range of 0.1 micron to 0.2 micron. The conformal nature of the coating results in the metal coating filling the troughs and ledges of the grooves such as to replicate the micro-replicated pattern. The metal film is then coated with a thin layer of the copolymer mixture (A, B) (Figure 6 (c)). The coating thickness can range from 0.01 micron to 0.1 micron, preferably in the range of 0.02 micron to 0.05 micron. The coating is once again conformal in nature such as to replicate the micro-replicated pattern. The copolymer coating is then coated with a thin film of the di-block copolymer. The components (A,B) of the di-block copolymer are the same as the components in the copolymer mixture. The thickness of the di-block copolymer can range from 0.05 micron to 1 micron, preferably between 0.1 micron to 0.25 micron.

For some embodiments, the use of a block copolymer including a component that can be cross-linked is desirable. This component can be cross-linked before or during removal of another component, and can therefore add structural integrity to the copolymer. This component can be referred to as the matrix component. Suitable matrix components include polystyrene, polybutadiene, polydimethylsiloxane, and other polymers. The component that is to be removed can be called the core component. Suitable core components include polymethylmethacrylate, polybutadiene, polycaprolactone or a photoresist.

Any block copolymers can be used, such as alkyl/alkyl, alkyl/aryl, aryl/aryl, hydrophilic/hydrophilic, hydrophilic/hydrophobic, hydrophobic/hydrophobic- , positively or negatively charged/positively or negatively charged, uncharged/positively or negatively charged, or uncharged/uncharged.

The copolymers may be containing nanoparticle, which may be metallic, semi-conducting or insulating in nature. Some examples of nanoparticles are gold, silver, cadmium selenide, silicon, zinc sulphide etc. The nanoparticles may be chosen such that during the phase separation of the polymers, the nanoparticles may or may not preferentially segregate into one polymer.

The copolymers may be containing biological materials such as DNA.

The copolymers can be coated from a common solvent or a mixture of co-solvents. To mobilize the molecules in the copolymer, the sandwich structure can be heated above the glass transition temperature of the copolymer.

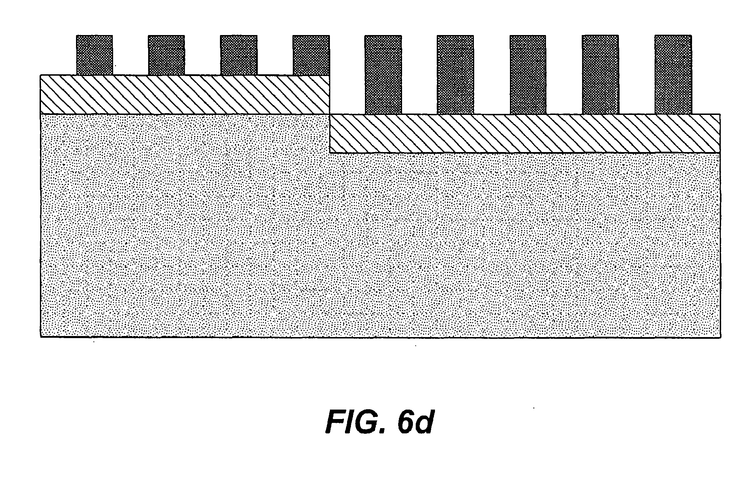

Next, as shown in Figure 6 (d) one of the components (e.g. core) of the di-block copolymer of the substrate-associated copolymer is removed. Removal of the component is achieved, e.g., by exposure to radiation (ultraviolet light, x-ray radiation, gamma radiation, visible light, heat, or an electron beam or any other radiation source which selectively degrades the minor component). Degradation or decomposing agents such as reactive oxygen species, including for example, ozone, or solvents such as ethanol, can also be used. Ultraviolet light can be used to degrade, for example, polymethylmethacrylate as a core component. Ethanol can be used to degrade, for example, polybutadiene.

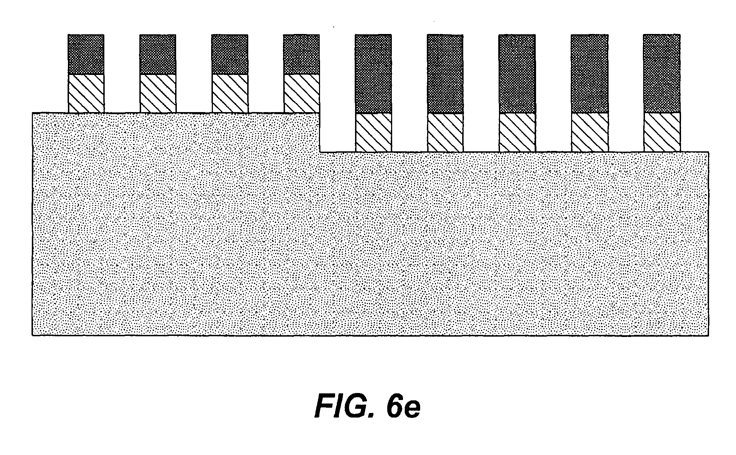

This treatment can be followed by a chemical rinse to remove the decomposition by-product, and typically results in porous material having pore (i.e. aperture) sizes in the tens of nanometer range. A step to remove any residual component can include treatment with a liquid, including washing with a solvent, or a material that reacts preferentially with the residual component, such as an acid or a base. In some embodiments, the material used to react with residual degraded component can be, for example, a dilute form of acetic acid. In this procedure, the same solvent or another solvent or etching solution is used to dissolve the metal. For example, sodium hydroxide can be used to etch aluminum (Figure 6(e)). The volume formerly filled by a now removed copolymer component and now comprises rectangular parallelepiped spaces extending through the thickness of the film to the substrate (for example, PET). The remaining volume is occupied by the remainder copolymer component and is referred to as the matrix.

In some embodiments, it may be desirable to optionally cross-link a component of the copolymer film. Cross-linking of a component that is not degraded by an energy source or agent can add structural strength to the film. In some embodiments, a copolymer component is cross-linked simultaneously with the degradation of another copolymer component. The radiation can optionally and desirably crosslink and substantially immobilize the matrix component of the diblock copolymer, so that the matrix maintains the array structure even after the rectangular parallelepiped voids are created. A nanoporous array template is the resulting overall structure. For example, in the case of polymethylmethacrylate (PMMA) in a polystyrene (PS) matrix, ultraviolet radiation degrades the PMMA while cross-linking the PS. It is desirable that the initial morphology of the copolymer be retained throughout the entire process of degradation. Other methods of removing one or the other component (e.g., chemical methods) can be used. The width of the apertures/voids can range from about 5 nm to about 500 nm or more, and the periodicity can range from about 5.0 to 500 nm.

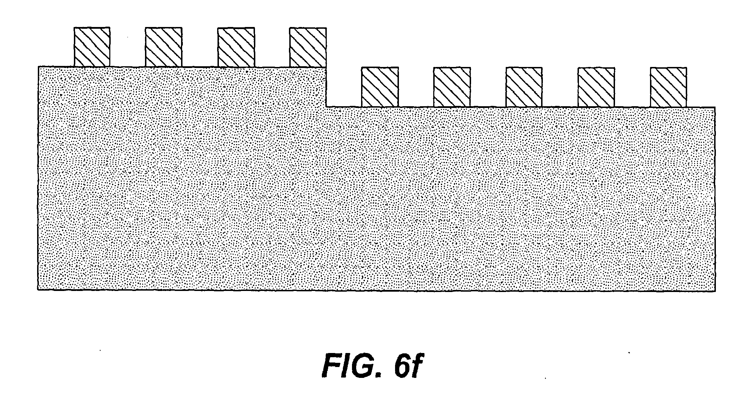

The final step (Figure 6 (f)) of the manufacturing process requires the matrix component of the di-block copolymer and any underlying copolymer coating to be removed by dissolution in an appropriate solvent or by radiation, etc. This process reveals a nanoarray of metal wires (e.g. aluminum), which could be used as light polarizers.

The invention has been described in detail with particular reference to certain preferred embodiments thereof, but it will be understood that variations and modifications can be effected within the spirit and scope of the invention.

## Claims

1. A method of forming a nanostructured pattern on a substrate comprising:
providing a substrate;
coating said substrate with functional material to form a layer of functional material;
coating said layer of functional material with a block copolymer of at least an A polymer chain and a B polymer chain;
drying said block copolymer to form ordered nanodomains;
removing the A polymer chain of the dried block copolymer to form voids; and
removing the functional material from where the A polymer chain has been removed.

2. The method of Claim 2 wherein said substrate is micropatterned.

3. The method of Claim 1 wherein said drying is performed with application of shear force external energy.

4. The method of Claim 1 wherein said drying is performed with application of an electric field.

5. The method of Claim 2 wherein said micropatterned substrate comprises grooves with a generally flat bottom and a pitch of less than 10 micrometers.

6. The method of Claim 1 wherein said functional material comprises an electrically conductive material.

7. The method of Claim 6 wherein said electrically conductive material is selected from the group consisting of aluminum, silver, gold, nickel, copper, indium tin oxide, antimony tin oxide, polythiophene, polyaniline and polyacetylene.

8. The method of Claim 1 wherein said A polymer chain comprises polymethylmethacrylate or polybutadiene and said B polymer chain comprises polystyrene.

9. The method of Claim I wherein said B polymer chain of said dried block copolymer is removed without removal of said functional material.

10. The method of Claim 5 wherein the grooves have a depth of between 50 and 600 nanometers.

11. The method of Claim 1 wherein said A polymer chain comprises acrylic polymer.

12. The method of Claim 1 wherein said B polymer chain comprises styrene.

13. The method of Claim 1 wherein said A polymer chain comprises at least one polymer selected from the group consisting of vinyl polymers, ethylene-vinyl acetate copolymers, polyacrylics, poly(acrylamide), polyacrylonitrile, poly(acrylic acid), ethylene-acrylic acid copolymers; ethylene-vinyl alcohol copolymers, polyether and polyol.

14. The method of Claim 1 wherein said B polymer chain comprises at least one polymer selected from the group consisting of poly(styrene); polyxylyene; vinyl polymers, ethylene-vinyl acetate copolymers, polyacrylics, poly(acrylamide), polyacrylonitrile, poly(acrylic acid), ethylene-acrylic acid copolymers; ethylene-vinyl alcohol copolymers, polyether, polyol, polyvinyl acetate and acetal.

15. The method of Claim 1 wherein the step of removing the A polymer chain comprises UV radiation degradation.

16. The method of Claim 1 wherein the step of removing the A polymer chain comprises solvent removal.

17. The method of Claim 1 wherein the substrate is selected from the group consisting of glass, thermoplastic resins, cellulose ethers, cellulose esters, polyolefins, polyacrylics, ethylene-vinyl alcohol copolymers, acrylonitrile copolymers, methyl methacrylate-styrene copolymers, ethylene-ethyl acrylate copolymers, methacrylated butadiene-styrene copolymers, polycarbonates polyether, polyketones, polyphenylenes, polysulfides; polysulfones, polylactones, polyurethanes, linear long-chain diols, polyether ether ketones, polyamides, polyesters, poly(arylene oxides), poly(arylene sulfides), polyetherimides, ionomers, poly(epichlorohydrins), furan resins such as poly(furan), silicones, polytetrafluoroethylenes, and polyacetals.

18. The method of Claim 1 wherein said A polymer chain is 10 nm to 100 nm in length.

19. The method of Claim 1 wherein said B polymer chain is 10 nm to 100 nm in length.

20. The method of Claim 1 further comprising removing the B polymer chain of the dried block copolymer
